(19) Europäisches Patentamt

European Patent Office

Office européen des brevets

(11) **EP 0 526 555 B1**

# (12) EUROPEAN PATENT SPECIFICATION

(45) Date of publication and mention
of the grant of the patent:
**13.01.1999 Bulletin 1999/02**

(21) Application number: **91908816.1**

(22) Date of filing: **25.04.1991**

(51) Int Cl.$^6$: **G01R 33/30**, G01R 33/34

(86) International application number:
**PCT/GB91/00654**

(87) International publication number:
**WO 91/17453 (14.11.1991 Gazette 1991/26)**

(54) **SAMPLE MOUNT FOR NMR MICROSCOPY**

PROBENHALTER FÜR KERNRESONANZ-MIKROSKOPIE

SUPPORT D'ECHANTILLON POUR EXAMEN MICROSCOPIQUE A RESONANCE MAGNETIQUE NUCLEAIRE

(84) Designated Contracting States:
**CH DE FR GB IT LI NL SE**

(30) Priority: **27.04.1990 GB 9009476**

(43) Date of publication of application:
**10.02.1993 Bulletin 1993/06**

(73) Proprietor: **BTG INTERNATIONAL LIMITED**
**London EC4M 7SB (GB)**

(72) Inventors:
• **MANSFIELD, Peter**
**Beeston Nottingham NG9 3DD (GB)**
• **GLOVER, Paul**
**Beeston Nottingham NG9 1PS (GB)**

(56) References cited:
**EP-A- 0 165 741**

• **Patent Abstracts of Japan, volume 12, no. 319 (P-751)(3166); & JP-A-6385437 (YOKOGAWA MEDICAL SYST LTD) 15 April 1988**
• **Medical Physics, volume 15, no. 6 November 1988 (New York, USA) Z.H. Cho et al.: "Nuclear magnetic resonance (NMR) microscopy with 4m resolution:", pages 815-824**
• **Review of Scientific Instr., volume 59, no. 6, (New York, US) D.W. White et al.: "Simple design for measurement of optical spectra in nuclear-magnetic-resonance tubes", pages 921-922**
• **Magnetic Resonance in Medicine, volume 4, no. 6, June 1987, (New York, USA) M. Fan et al.: "A UHF probe for NMR micro-imaging experiments", pages 591-596**
• **Angewandte Chemie, volume 29, no. 1 January 1990, (Weinheim, DE) W. Kuhn "NMR Microscopy - Fundamentals limits and possible applications", pages 1-19**

**Description**

The present invention relates to sample mounts for NMR microscopy and spectroscopy and more particularly to a sample mount which can be used for both optical microscopy and NMR microscopy by which is meant the production of two dimensional images of the object and/or the production of NMR spectra.

In optical microscopy tissuc specimens and cell cultures are prepared for examination by staining in order to increase contrast so as to highlight particular structures.

Japanese Patent Abstract JP-A-63-85437 (Yokogawa Medical Systems Ltd) discloses an MRI microscope which enables a sample to be optically observed while an MRI image is displayed. A sample mount into which a sample is placed is positioned within a fixed RF transmitting and receiving coil system. While this mounting arrangement allows for unrestricted optical viewing, it limits the electrical coupling between the coil system and the sample.

It is an object of the invention to provide a sample mount in which a magnetic resonance signal generated in a sample can be more effectively transmitted therefrom.

According to the invention, a sample mount for NMR spectroscopy and optical microscopy comprises a substrate layer; an RF coil mounted adjacent to the substrate layer; a cover slip mounted adjacent to the RF coil on the opposite side to the substrate layer and adapted to receive a sample, the cover slip and substrate layer being sealed together to environmentally seal the RF coil; a tuned circuit comprising the RF coil and additional components mounted integrally on the substrate layer; and non-contact coupling means on the substrate layer provided, in use, to couple a signal generated in the tuned circuit by a sample mounted on the cover slip to signal processing means external to the sample mount.

Preferably, the substrate layer and the cover slip are both transparent to enable a sample mounted on the cover slip to be viewed in an optical microscope.

In carrying out the invention, a further cover slip may be included which is located on the opposite side of the cover slip to the substrate layer, the further cover slip being removably mounted on and spaced from the aforesaid cover slip to enable a sample for examination to be positioned between the two cover slips.

The coupling means may be inductive, capacitive or radiative.

Embodiments of the present invention will now be described, by way of example with reference to the accompanying drawings, in which:-

Figure 1 shows a side view of a sample mount according to the present invention illustrating a slide coil arrangement and in which the position of a typical specimen is also indicated;

Figure 2 shows a plan view of the slide coil arrangement of Figure 1 shows an RF coil and tuning arrangement, the coil being sealed between the slide substrate and cover slip;

Figure 3 shows an equivalent circuit of the slide mounted coil and tuning arrangement (circuit 2); also shown in the circuit drive and coupling inductor $L_1$, alternative capacitive drive arrangement being provided when points A and B are joined together and $L_1$ replaced by a capacitor $C_2$;

Figure 4 shows the effective circuit of the slide coil arrangement shown in Figure 2;

Figure 5(a) shows an optical micrograph of one layer of onion cells;

Figure 5(b) shows an NMR image of one layer of onion cells, the image comprises 256 x 256 pixels with 4.7 μm in-plane resolution;

Figure 6 shows an alternative slide coil arrangement which uses a separate inductive coil;

Figure 7(a) shows an alternative slide coil arrangement in which the $B_1$ field is produced by a flat conductive strip or set of parallel wires. This coil arrangement is fixed to a glass substrate and protected by a glass cover slip. The specimen is brought close to a place and the effective magnetic field B is enhanced and made uniform by the presence of a highly conductive metallic sheet;

Figure 7(b) shows a side view of the slide coil arrangement in Figure 7(a);

Figure 8 shows a plastic holder forming part of an NMR probe illustrating accurate positioning of the slide within an NMR apparatus, and

Figure 9 shows schematically the slide and slide mount located within an NMR apparatus.

In the NMR specimen mount according to the present invention, sample 100 is placed on a slide 200 which includes an integrated tuned RF coil 202. The RF coil is sealed between a standard glass microscope slide substrate 204 and a first cover slip 206 so the whole slide assembly can be washed for re-use. The use of a glass substrate allows for the sample 100 to be viewed under a normal optical microscope but if this is not required then the slide substrate 204 could be made from a suitable synthetic plastics material or other material. The sample 100 is placed between the first cover slip 206 and a second, removable cover slip 208.

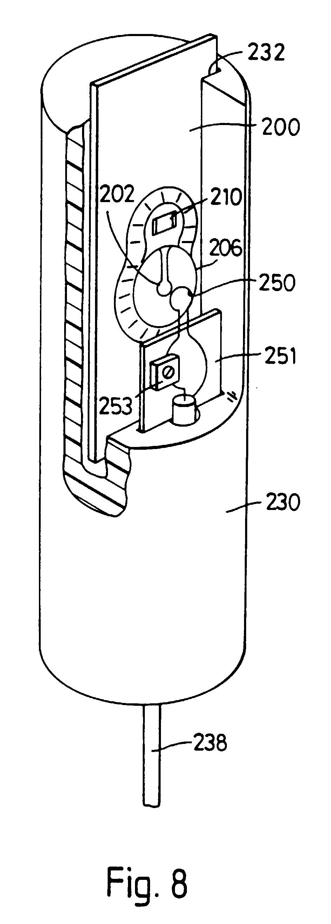

The slide 200 can be examined using conventional optical microscopy and then placed in an NMR magnet (not shown) and imaged, or spectroscopic information obtained using the optical picture as a guide to particular areas of interest. There is no physical link to the slide, signals picked up in the coil 202 being coupled to a loosely coupled secondary coil (see for example Figure 8) which is preferably matched to 50Ω.

The slide assembly mounts on an RF stage of an NMR apparatus in a holder (Figure 8) which positions the sensitive region in the centre of the gradient coil (not shown). The microscopy slide system would be particularly suitable for use with flat gradient coils.

NMR apparatus and gradient coils for use therein are well known and these will not j therefore be further described. The operation is as follows:-

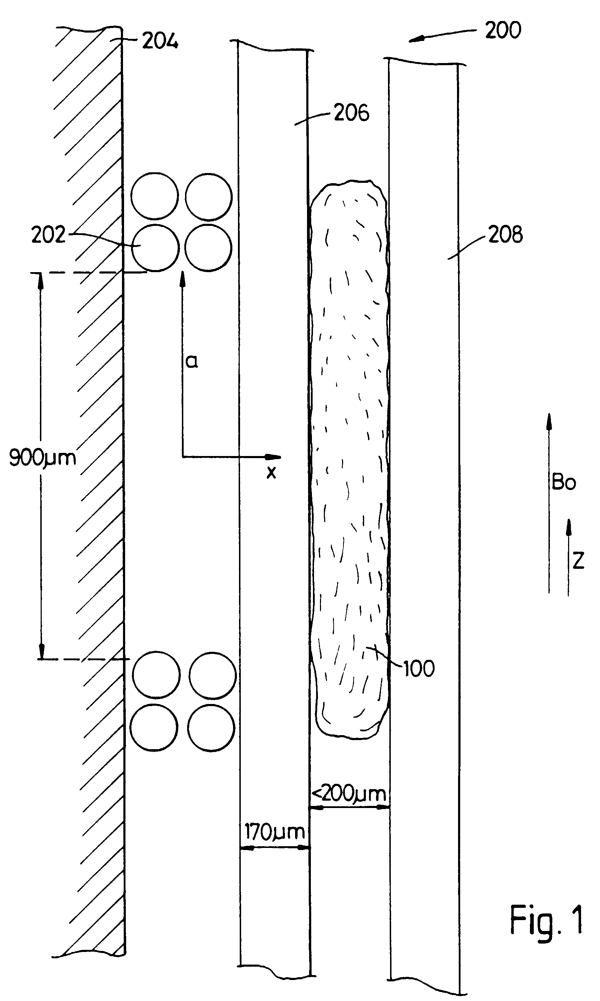

The sample 100 is placed close to the RF coil 202 which is flat, i.e. substantially planar comprising N turns, Figure 1. Let the coil radius be $\underline{a}$ and the axial distance from the centre of the coil be $\underline{x}$. The field $B_x$ at distance $\underline{x}$ from coil is

$$B_x = \frac{\mu_o N I a^2}{2(x^2 + a^2)^{3/2}}$$

The field relative to that obtained at the coil centre is

$$B_{rel} = \frac{1}{(k^2 + 1)^{3/2}}$$

where k is given by

$$x = ka$$

Over a 100 μm slice using a 900 μm diameter RF coil 202 and 170 μm cover slips 206 and 208, the average $B_{rel}$ approaches 0.85 so that this arrangement, though not perfect loses only around 15% of the available signal.

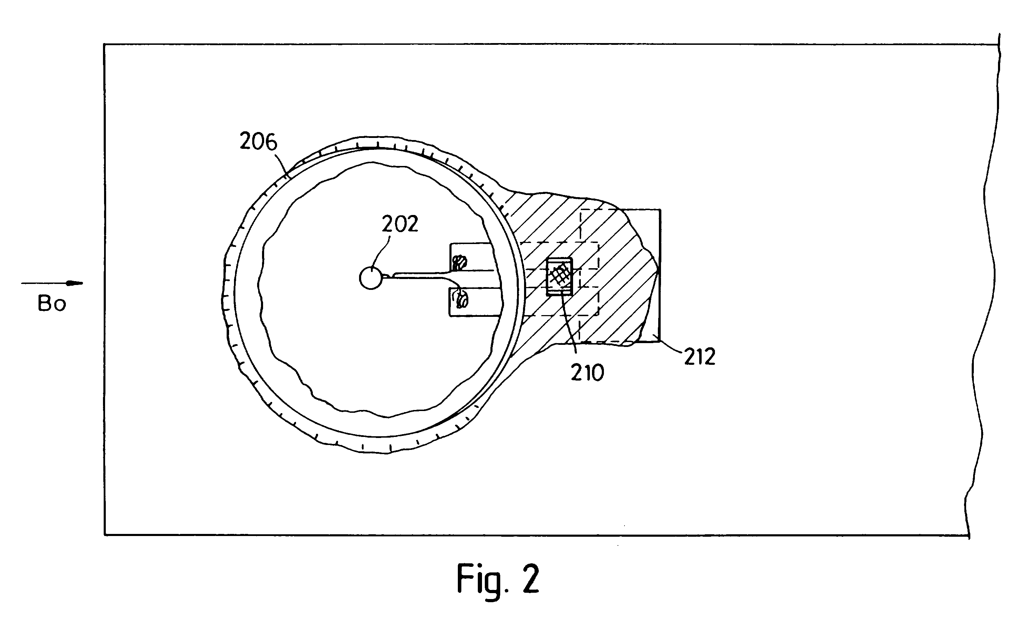

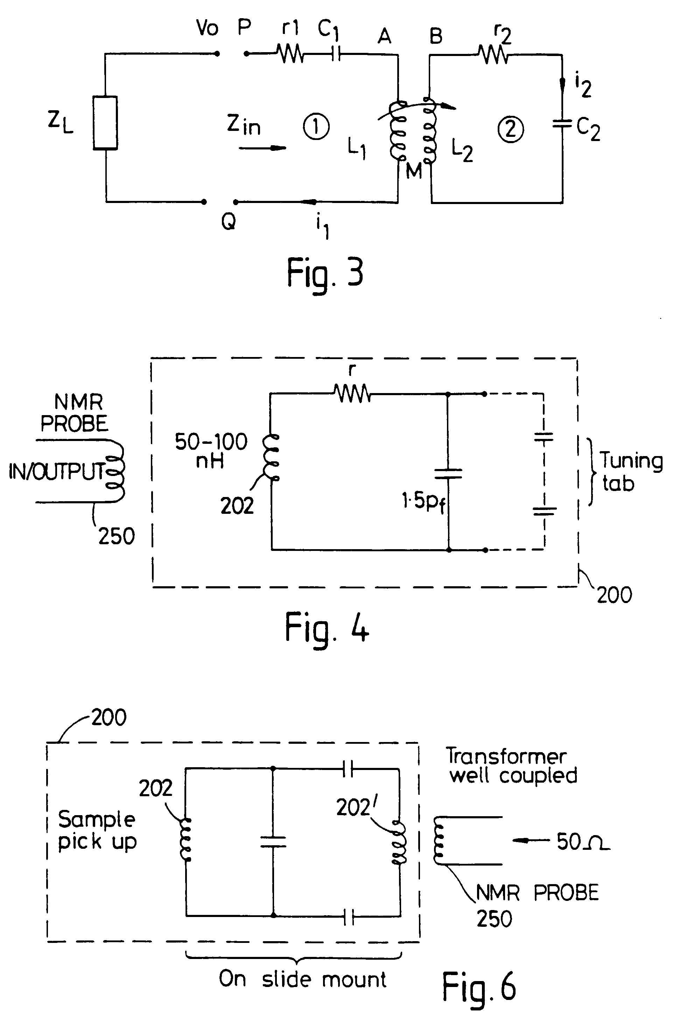

A plan view of the slide coil arrangement is shown in Figure 2. The RF coil forms part of the resonant circuit tuned with a chip capacitor (210). Fine tuning is achieved with a sliding copper foil trimmer 212. The RF coil 202 is inductively coupled to the transmitter/receiver system of the NMR microscopy (now shown). The circuit arrangement is represented schematically in Figure 3.

For the $i_1$ loop we have

$$V_o - j\omega L_1 i_1 - (i_1/j\omega c_1) - i_1 r_1 + j\omega M i_2 = 0$$

where $V_o$ is the output voltage across points P and Q, $i_1$ is the primary current in loop 1, $i_2$ is the secondary current in loop 2, $r_1$, $c_1$ and $L_1$ are resistance series capacitance and inductance of loop 1. M is the mutual inductance between loops 1 and 2. $r_2$, $c_2$ and $L_2$ are the resistance, capacitance and inductance respectively of loop 2.

For the $i_2$ loop we have

$$j\omega M i_1 - j\omega L_2 i_2 - i_2 r_2 - i_2/j\omega c_2 = 0$$

which gives

$$i_2 = i_1 j\omega M / (j\omega L_2 + r_2 + 1/_{j\omega c2})$$

The input impedance is given by

$$Z_{in} = V_{o/i1} = j\omega L_1 + 1/_{j\omega C1} + r_1 + \frac{\omega^2 M^2}{j_\omega L_2 + r_2 + 1/j_\omega C_2}$$

At resonance $j\omega L_1 = -1/_{j\omega C1}$ and $j\omega L_2 = -1/_{j\omega c2}$ which gives

$$Z_{in} = \frac{\omega^2 M^2}{r_2} + r_1 = r_1(1+Q^2 k^2)$$

where

$$k = \frac{M}{\sqrt{(L_1 L_2)}}$$

and Q is the quality factor.

Experimentally the coefficient of coupling k is approximately 0.01.

The voltage transfer function $V_o = -i_1 Z_L$. For the $i_1$ loop where $Z_L$ is the load impedance and $V_o$ is the load voltage.

$$V_o - i_1 r_1 - j\omega L_1 i_1 + j\omega M i_2 - i_1/j\omega c_1 = 0$$

and for the $i_2$ loop

$$-V_2 + j\omega M i_1 - j\omega L_2 i_2 - i_2 r_2 - i_2/j\omega c_2 = 0$$

Combining these results we obtain

$$V_o(1 + r_1/Z_L + j\omega L_1/Z_L + 1/Z_L j\omega c_1) = \frac{V_2 j\omega M}{r_2} + \frac{\omega^2 M^2 V_o}{r_2 Z_L}$$

At resonance the above result reduces to

$$V_o \left(1 + r_1/Z_L + \frac{Z_{in}\text{-}r_1}{Z_L}\right) = jV_2 \left[\frac{Z_{in} - r_1}{r_2}\right]^{\frac{1}{2}}$$

If $r_1 \ll Z_L$ and $Z_{in} = Z_L$ then

$$V_o = \frac{jV_2}{2} \left[\frac{Z_{in}}{r_2}\right]^{\frac{1}{2}}$$

This result is identical to that obtained when the tuned coil 202 is directly coupled to the transmitter/receiver system, i.e. when A is joined to B and $L_1$ is replaced by a capacitor $C_{2'}$. In this case

$$Z_{in} = r_2 Q^2 (C_1/C_2)^2$$

for $C_2 > C_1$. Setting $k = (C_1/C_2)^2$ gives the same result as that for inductive coupling. The electrical equivalence of the two coupling arrangements means that inductive coupling may be used without degrading the signal reception, thus obviating solder or other connections.

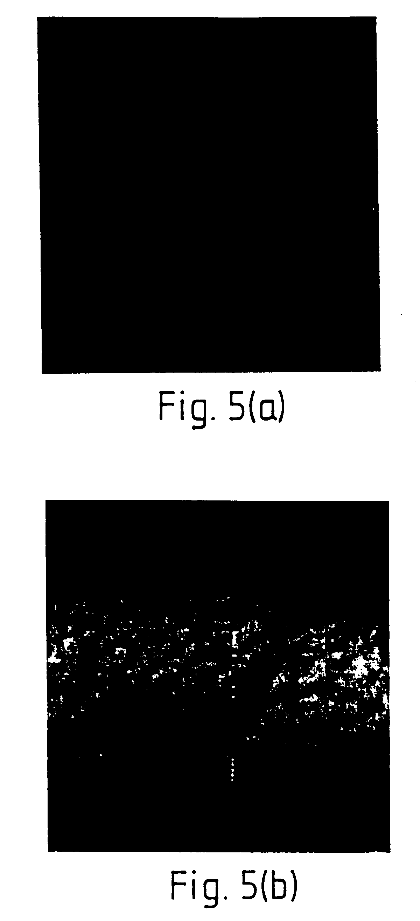

Figures 1 and 2 show the construction of the slide coil. The effective circuit on the slide is shown in Figure 4. The coil assembly is sealed against liquid ingress using cover slip 206. The copper foil tuning tab 212 on the reverse side of the slide is at earth potential thus electrically balancing the coil 202. The chip capacitor 210 is preferably placed about 10 mm from the coil 202 thereby minimising its adverse effects on an image due to the ceramic and metal parts it contains. The coil 202 preferably comprises 4 - 6 turns of polyurethane insulated 34 SWG copper wire. The microscope slide 200 is placed in a holder (not shown) which contains a pickup coil (not shown) that couples to the slide circuit and also contains components for further tuning and matching of the unit.

Images of cells at less than 5 μm resolution have been obtained where the average thickness of the cells is around 70μm. The quality of the results is dependent on sample preparation which must exclude air bubbles which cause image artefacts due to local gradients. The right liquid medium is important to achieve susceptibility matching. Water with various dopants seems best but we have tried organic solvents like $CC1_4$.

Using gadolinium or manganese doped water good susceptibility matching is achieved and good outline of the cell structure produced with an inversion recovery NMR sequence to null out the extra cellular water.

Figure 5 shows a comparison between an optical micrograph of a layer of onion cells 5a and the corresponding NMR image 5b. In this example Gd-DPTA/ water was used to match susceptibility across the extra cellular spaces. The NMR resolution was 4.7 μm.

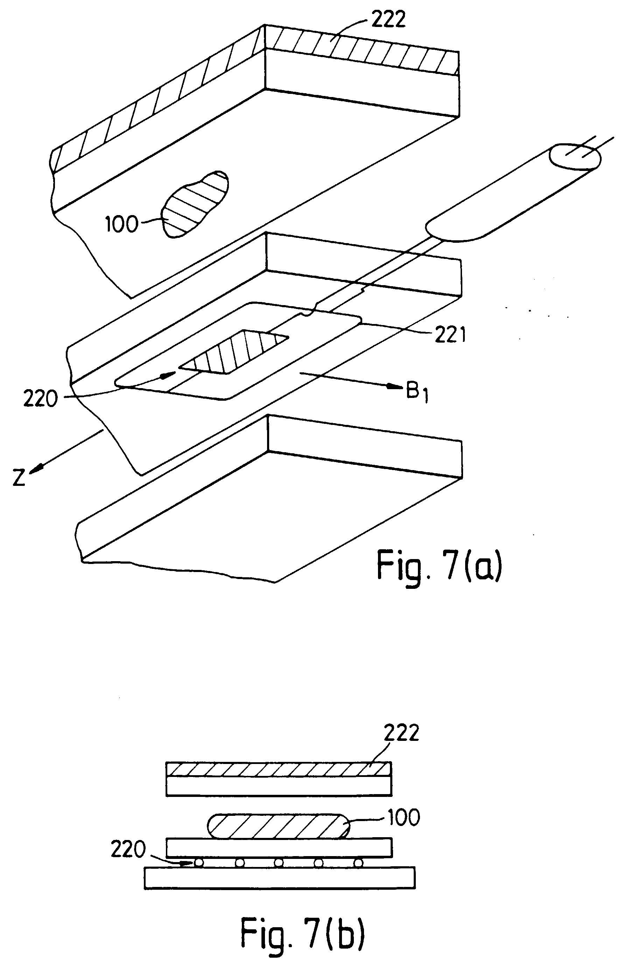

There are three categories of non-contact coupling: capacitive, inductive and radiative. Capacitive coupling can be used to the slide mounted circuit and requires an arrangement of plates to couple, tune and match. The examples of inductive methods described above require only loose coupling which imposes fewer mechanical constraints. A further approach which would allow more space around the sample area and also obviate coupling to the coil is to use a second coil 202 on the slide 200 as in Figure 6. An optimum circuit geometry which takes account of the inductive loop and resistance of the leads to the capacitor may be approached experimentally. In a further modification the receiver coil is set into the cover plate 206 or a depression is made in the glass plate 206 to bring the sample closer to the receiver coil, thus increasing the filling factor. In yet further modifications an RF preamlifier (not shown) is included on the slide. In this arrangement coupling to the NMR microscope receiver system would be by either an inductive or capacitive link. In this case there would have to be a separate decoupled transmitter coil.

In a third coupling mode, the NMR signal could be transmitted via an antenna from a micro-transmitter housed on the slide mount.

An advantage of the flat coil 202 is its restricted field of view. However, this results in a lower filling factor and a spatially inhomogenous RF field. A larger filling factor and more uniform field would be obtained using two coils in a Helmholtz arrangement.

Further flat coil arrangements are possible in which a wire coil array or a single flat conducting strip 220, with current return path 221, Figure 7, is brought close to a conducting sheet 222 with the specimen sandwiched between. The presence of the conducting sheet increases the RF field in the sample, improving both signal sensitivity and RF homogeneity. The conductive sheet may be a metallic glass substrate. For this arrangement coupling to the strip coil 220 may be by direct connection or by a capacitive, inductive or radiative link, as described above.

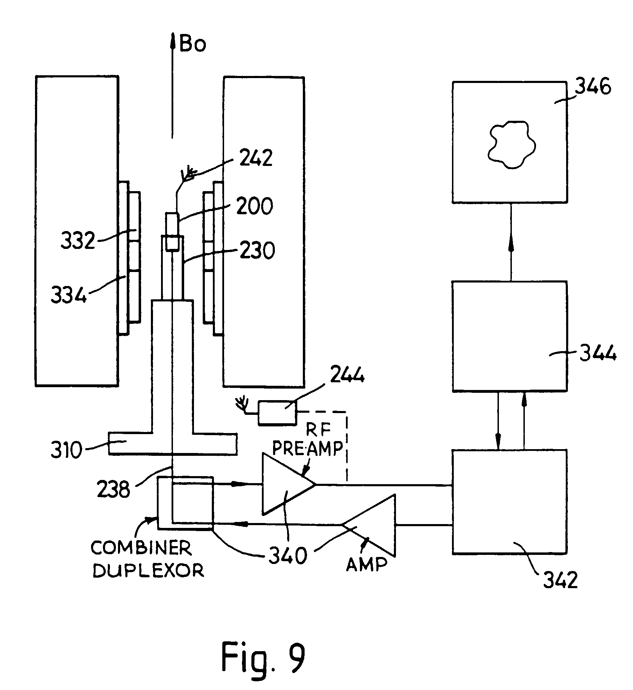

With reference now to Figures 8, 9, the slide 200 is shown mounted in a suitable plastic holder 230 which forms part of NMR probe 310 and is mounted within an NMR apparatus 300 which in a known manner comprises a permanent magnet 331 gradient and field coil structures 332, 334. (Further description of the operation of the NMR apparatus is considered unnecessary since the techniques for such operation though both complex and varied are well know to those skilled in the art).

The slide 200 is mounted onto a synthetic plastics holder 230 which forms part of an NMR probe. The holder 230 will be accurately positioned in a defined position within an NMR apparatus and the slide will be therefore accurately positioned within the holder 230 and hence within the NMR apparatus.

The slide 200 is held in holder 230 by, for example, a slotted arrangement 232. RF pickup coil 250 for the NMR apparatus is mounted into the holder 230 and the coil 202 in the sample mount 200 is thus aligned accurately with this RF coil 250 and also with the gradient coils 332. RF coil 250 is connected to a printed circuit board 251 for support and a tuning capacitor 253 also positioned on this board.

The NMR RF Feed/output is taken via cable 238 to suitable transmitter/amplifier apparatus 340 (Figure 9). A suitable NMR spectrometer 342, computer 344 and display apparatus 346 is shown and operates in known manner.

Alternatively as described hereinbefore a microtransmitter/ antenna arrangement 242 could be incorporated into the slide mount to directly transmit the NMR signal to a suitable receiver 244 (Figure 9).

## Claims

1. A sample mount for NMR spectroscopy comprising: a substrate layer (204); an RF coil (202) mounted adjacent to the substrate layer (204); a cover slip (206) mounted adjacent to the RF coil (202) on the opposite side to the substrate layer (204) and adapted to receive a sample (100), the cover slip (206) and substrate layer (204) being sealed together to environmentally seal the RF coil (202): a tuned circuit comprising the RF coil (202) and additional components (210, 212) mounted integrally on the substrate layer (204); and non-contact coupling means on the substrate layer provided, in use, to couple a signal generated in the tuned circuit by a sample (100) mounted on the cover slip (206) to signal processing means external to the sample mount.

2. The sample mount according to Claim 1 in which the substrate layer (204) and the cover slip (206) are both transparent to enable a sample (100) mounted on the cover slip (206) to be viewed in an optical microscope.

3. The sample mount according to either one of the preceding claims and including a further cover slip (208) located on the opposite side of the cover slip (206) to the substrate layer (204), the further cover slip (208) being removably mounted on and spaced from the aforesaid cover slip (206) to enable a sample (100) for examination to be positioned between the two cover slips (206 and 208).

4. The sample mount according to Claim 3 in which the space between the cover slips (206 and 208) is adapted to enable a sample (100) positioned between them to be immersed in a suitable liquid medium.

5. The sample mount according to any one of the preceding claims in which the coupling means is inductive and acts to inductively couple the RF coil (202) to a transmitter coil of an NMR probe (250) so that the RF coil (202) behaves both as an RF transmitter to and receiver of signals from a sample (100) mounted on the cover slip (206).

6. The sample mount according to any one of Claims 1 to 4 in which the coupling means is capacitive.

7. The sample mount according to any one of Claims 1 to 4 in which the coupling means is radiative.

8. The sample mount according to any one of the preceding claims in which the tuned circuit also includes as an additional component a variable capacitor (212) for fine tuning.

9. The sample mount according to Claim 8 in which the variable capacitor comprises a sliding metal foil trimmer (212).

10. The sample mount according to any one of the preceding claims and including an integral RF preamplifier for the signal generated in the tuned circuit.

11. The sample mount according to any one of the preceding claims in which the RF coil (202) is formed as a wire coil array or flat conductive strip (220), and a conducting sheet (222) is placed in proximity to the RF coil (202).

**Patentansprüche**

1. Probenträger für NMR-Spektroskopie mit: einer Substratschicht (204); einer an die Substratschicht (204) angrenzend angeordneten HF-Spule (202); ein angrenzend an die HF-Spule (202) auf der der Substratschicht (204) gegenüberliegenden Seite angeordnetes und zum Aufnehmen einer Probe (100) ausgelegtes Deckplättchen (206), wobei das Deckplättchen (206) und die Substratschicht (204) miteinander versiegelt sind, um die HF-Spule (202) gegen die Umgebung abzudichten; einem abgestimmten Schaltkreis, der die HF-Spule (202) und zusätzliche Bauteile (210, 212) umfaßt, die als Einheit auf der Substratschicht (204) angeordnet sind; und kontaktlose Kopplungseinrichtungen auf der Substratschicht, um beim Betrieb ein Signal, das in dem abgestimmten Schaltkreis durch eine Probe (100), die auf dem Deckplättchen (206) angeordnet ist, erzeugt wurde, zu Signalverarbeitungseinrichtungen außerhalb des Probenträgers zu übertragen.

2. Probenträger nach Anspruch 1, bei dem die Substratschicht (204) und das Deckplättchen (206) beide durchsichtig sind, um zu ermöglichen, daß eine auf dem Deckplättchen (206) angeordnete Probe (100) in einem optischen Mikroskop betrachtet werden kann.

3. Probenträger nach einem der vorhergehenden Ansprüche, und der ein weiteres Deckplättchen (208) umfaßt, das sich auf der anderen Seite des Deckplättchens (206) als der zu der Substratschicht (204) hin befindet, wobei das weitere Deckplättchen (208) abnehmbar auf dem vorgenannten Deckplättchen (206) angebracht und von diesem beabstandet ist, um zu ermöglichen, daß eine zu untersuchende Probe (100) zwischen den beiden Deckplättchen (206 und 208) angeordnet ist.

4. Probenträger nach Anspruch 3, bei dem der Raum zwischen den Deckplättchen (206 und 208) ausgelegt ist, um zu ermöglichen, daß eine zwischen diesen angeordnete Probe (100) in ein geeignetes flüssiges Mittel eingetaucht wird.

5. Probenträger nach einem der vorhergehenden Ansprüche, bei dem die Kopplungseinrichtung induktiv ist und so wirkt, daß die HF-Spule (202) induktiv mit einer Übertragerspule (250) einer NMR-Sonde gekoppelt ist, so daß sich die HF-Spule (202) sowohl wie ein HF-Übertrager als auch wie ein HF-Empfänger von Signalen von einer auf dem Deckplättchen (206) angeordneten Probe (100) verhält.

6. Probenträger nach einem der Ansprüche 1 bis 4, bei dem die Kopplungseinrichtung kapazitiv ist.

7. Probenträger nach einem der Ansprüche 1 bis 4, bei dem die Kopplungseinrichtung auf Strahlung basiert.

8. Probenträger nach einem der vorherigen Ansprüche, bei dem der abgestimmte Schaltkreis außerdem als zusätzliches Bauteil einen verstellbaren Kondensator (212) für eine Feinabstimmung enthält.

9. Probenträger nach Anspruch 8, bei dem der verstellbare Kondensator einen Gleitmetallfolientrimmer (212) umfaßt.

10. Probenträger nach einem der vorhergehenden Ansprüche, und der einen eingebauten HF-Vorverstärker für das in dem abgestimmten Schaltkreis erzeugte Signal enthält.

11. Probenträger nach einem der vorhergehenden Ansprüche, bei dem die HF-Spule (202) als Gruppe von Drahtspulen oder als flacher leitender Streifen (220) ausgebildet ist, und eine leitende Platte (222) ist in der Nähe der HF-Spule (202) angeordnet.

## Revendications

1. Support d'échantillon pour spectroscopie par RMN; comprenant: une couche de substrat (204); une bobine HF (202) montée au voisinage immédiat de la couche de substrat (204); un couvre-objet (206) monté au voisinage immédiat de la bobine HF (202), à l'opposé par rapport à la couche de substrat (204), et apte à recevoir un échantillon (100), le couvre-objet (206) et la couche de substrat (204) étant fixés hermétiquement l'un à l'autre pour isoler la bobine HF (202) de son environnement; un circuit accordé comprenant la bobine HF (202) et des composants supplémentaires (210, 212) montés d'une seule pièce sur la souche de substrat (204); et un moyen de couplage sans contact sur la couche de substrat servant, en service, à transmettre un signal généré dans le circuit accordé par un échantillon monté sur le couvre-objet (206) à un moyen de traitement de signal situé à l'extérieur du support d'échantillon.

2. Support d'échantillon selon la revendication 1, dans lequel la couche de substrat (204) et le couvre-objet (206) sont tous deux transparents pour permettre de voir dans un microscope optique un échantillon (100) monté sur le couvre-objet.

3. Support d'échantillon selon l'une ou l'autre des revendications précédentes et comprenant un autre couvre-objet (208) situé du côté opposé du couvre-objet (206) par rapport à la couche de substrat (204), l'autre couvre-objet (208) étant monté de manière amovible sur et à distance du couvre-objet précité (206) pour permettre de disposer entre les deux couvre-objets (206 et 208) un échantillon (100) à examiner.

4. Support d'échantillon selon la revendication 3, dans lequel l'espace entre les couvre-objets (206 et 208) sert à permettre à un échantillon (100) disposé entre eux d'être immergé dans un milieu liquide approprié.

5. Support d'échantillon selon l'une quelconque des revendications précédentes, dans lequel le moyen de couplage est inductif et sert à coupler par induction la bobine HF (202) à une bobine d'émission (250) d'une sonde à RMN afin que la bobine HF (202) se comporte à la fois comme un émetteur HF vers et comme un récepteur de signaux provenant d'un échantillon (100) monté sur le couvre-objet (206).

6. Support d'échantillon selon l'une quelconque des revendications 1 à 4, dans lequel le moyen de couplage est capacitif.

7. Support d'échantillon selon l'une quelconque des revendications 1 à 4, dans lequel le moyen de couplage est radiatif.

8. Support d'échantillon selon l'une quelconque des revendications précédentes, dans lequel le circuit accordé comprend aussi comme composant supplémentaire un condensateur variable (212) pour accord fin.

9. Support d'échantillon selon la revendication 8, dans lequel le condensateur variable comporte un condensateur ajustable non métallisé coulissant (212).

10. Support d'échantillon selon l'une quelconque des revendications précédentes et comprenant un préamplificateur HF intégré pour le signal généré dans le circuit accordé.

11. Support d'échantillon selon l'une quelconque des revendications précédentes, dans lequel la bobine HF (202) est réalisée sous la forme d'une rangée de bobines de fil ou d'une bande conductrice plane (220); et une feuille conductrice (222) est placée à proximité de la bobine HF (202).

Fig. 1

Fig. 2

EP 0 526 555 B1

Fig. 3

Fig. 4

Fig. 6

Fig. 5(a)

Fig. 5(b)

Fig. 7(a)

Fig. 7(b)

Fig. 8

Fig. 9